# EUROPEAN PATENT APPLICATION

(11) **EP 4 324 678 A1**
(43) Date of publication of application: **21.02.2024**
(21) Application number: 22191155.5
(22) Date of filing: 19.08.2022
(51) Int. Cl.: B60L 1/02, B60L 3/00, B60L 50/51, B60L 53/20, H02K 5/15, H02K 5/173, H02K 5/20, H02K 7/116, H02K 9/19, H02K 11/33, B60K 11/02, B60K 1/00, H05K 7/20, F28D 9/00, F28D 21/00

(54) **ARRANGEMENT INCLUDING AN ELECTRIC POWER CONVERTER WITH IMPROVED COOLING CONCEPT**

(71) Applicant: Valeo eAutomotive Germany GmbH, 91056 Erlangen (DE)
(72) Inventor: Lewandowski, Marek, 91056 Erlangen (DE); REYMANN, Markus, 91056 Erlangen (DE)
(74) Representative: Valeo Powertrain Systems

(57) **Abstract**

An arrangement is disclosed, which comprises a water oil heat exchanger (2d) having a base body (3d) with a heat exchanger water channel and a heat exchanger oil channel and an electric power converter (4d) with a plurality of electronic power switches, which are mounted on or in the base body (3d) of the water oil heat exchanger (2d). Moreover, the invention relates to an electric drive unit (17a), which comprises a housing (19), an electric motor (12b) and a gear unit (18) being arranged in the housing (19), and a drive unit oil channel (26) in the housing (19) for cooling the same, which is connected to the heat exchanger oil channel of the arrangement. Finally, the invention relates to a vehicle with an electric drive unit (17a), which is provided to propel the vehicle (28).

## Description

### TECHNICAL FIELD

The invention relates to an arrangement, which comprises a water oil heat exchanger having a base body with a heat exchanger water inlet, a heat exchanger water outlet, a heat exchanger water channel between the heat exchanger water inlet and the heat exchanger water outlet, a heat exchanger oil inlet, a heat exchanger oil outlet and a heat exchanger oil channel between the heat exchanger oil inlet and the heat exchanger oil outlet. Moreover, the arrangement comprises an electric power converter with a plurality of electronic power switches. Moreover, the invention relates to an electric drive unit, which comprises a housing, an electric motor arranged in the housing, a gear unit, which is arranged in the housing and which is mechanically coupled to the electric motor, and a drive unit oil channel arranged in the housing at least in the region of the electric motor for cooling the same. Finally, the invention relates to a vehicle with an electric drive unit of the above kind, which is provided to propel the vehicle at least partially or intermittently.

### BACKGROUND ART

An arrangement, an electric drive unit and a vehicle of the aforementioned kinds are generally known. During operation, the electric drive unit generates waste heat, mainly in its electric motor and in its electric power converter, which is used to alternatingly power the windings from the electric motor for generation of a rotating electromagnetic field. Because natural heat dissipation (e.g. radiation and/or convection) is not sufficient to keep the electric drive unit and the electric power converter sufficiently cool in some applications like in an electric vehicle, the electric motor can be oil cooled and the electric power converter can be water cooled. The gear unit usually does not generate much waste heat and can passively be cooled. However, the gear unit can also be oil cooled for example.

Provision of different cooling circuits is technically complicated, in particular when there is just limited available space like it is the case in electric cars. Manufacturing and later on maintenance can become a challenging task if the arrangement, the electric drive unit and/or the vehicle is not designed properly. Moreover, known embodiments of said entities are not very robust against unfavorable conditions like vibrations in an electric vehicle, and the cooling circuits can get damaged easily.

### DISCLOSURE OF INVENTION

Accordingly, an object of the invention is to provide an improved arrangement, an improved electric drive unit and an improved electric vehicle. In particular, a solution shall be proposed, which is less complicated and ensures easy manufacturing and maintenance of said entities and reduces design effort. Moreover, robustness of said entities shall be increased.

The object of the invention is solved by an arrangement as disclosed in the opening paragraph, wherein at least the electronic power switches of the electric power converter are mounted on or in the base body of the water oil heat exchanger. Moreover, the object of the invention is solved by an electric drive unit ("e-axle") as disclosed in the opening paragraph, which comprises an arrangement of the above kind, which is arranged on or in the housing of the electric motor, wherein
- the electric power converter of the arrangement is electrically connected to the electric motor and wherein
- the heat exchanger oil channel of the arrangement and the drive unit oil channel are interconnected (in particular directly interconnected) via the heat exchanger oil inlet or heat exchanger oil outlet.

In addition, the object of the invention is solved
- by a vehicle, with an electric drive unit of the above kind, which is provided to propel the vehicle least partially or intermittently or
- by a vehicle, which comprises an electric drive unit, which is provided to propel the vehicle least partially or intermittently, and which comprises an arrangement of the above kind, wherein the power converter is electrically connected to the electric drive unit and wherein the water oil heat exchanger is hydraulically connected to the electric drive unit.

By the proposed measures, technical complexity of an arrangement, an electric drive unit and a vehicle can be reduced. That is why, the said entities can be designed, manufactured and maintained easier compared to known solutions. Moreover, said entities are more robust against unfavorable conditions like vibrations in an electric vehicle because of the special measures.

For example, the electric motor can be oil cooled, the electric power converter can be water cooled and the gear unit can be passively cooled.

"Directly interconnected" in the above context in particular means "without the use of additional tubes". Instead, the connection between the drive unit oil channel and the heat exchanger oil channel can be provided by body contact of the housing of the electric drive unit and the water oil plate heat exchanger, as the case may be with an optional sealing in-between. Alternatively, the connections between the drive unit oil channel and the converter oil channel and the converter oil channel and the heat exchanger oil channel can be provided by body contact of the respective parts, too, again with optional sealings in-between as the case may be. The converter oil channel for example may be embodied as a simple hole in the electric power converter, which connects the drive unit oil channel and the heat exchanger oil channel.

Further advantageous embodiments are disclosed in the claims and in the description as well as in the figures.

Beneficially, a control unit of the electric power converter for controlling the electronic power switches and/or a DC link capacitor of the electric power converter electrically connected to the electronic power switches can be arranged on or in the base body of the water oil heat exchanger. In this way, technical complexity of the arrangement can further be reduced and the control unit and/or a DC link capacitor can be cooled, too.

In a very advantageous embodiment of the invention, the arrangement can comprise an electric motor, wherein the base body of the water oil heat exchanger forms a housing of said electric motor or a housing part of a housing of said electric motor. In this way, the electric motor can provide a plurality of functions. First, it provides mechanical power at its rotor shaft. Second, its housing provides heat transfer between a water flow and an oil flow. Third, waste heat from the electric motor is transferred to the water flow and/or to the oil flow. Fourth, waste heat from the electronic power switches of the electric power converter is transferred to the water flow and/or to the oil flow, too. For example, the housing of the electric motor or base body can comprise an oil channel. Furthermore, a water channel can be provided, which is formed by a tube running along the oil channel. The oil channel and the water channel in particular may helically run around the stator of the electric motor. On top of the housing or base body, the electric motor can comprise the electronic power switches of the electric power converter, which for example may be embodied as field effect transistors or insulated-gate bipolar transistors. The electric power converter is used to alternatingly power the windings of the electric motor for generation of a rotating electromagnetic field.

Beneficially, the water oil heat exchanger can be embodied as a water oil plate heat exchanger. Accordingly, the desired function is provided by proven means.

Beneficially, the water oil plate heat exchanger can comprise a plate stack of a plurality of heat exchanger plates, which alternatingly and pairwise form sections of the heat exchanger water channel and sections of the heat exchanger oil channel in-between and can comprise the base body, which
- is mounted to the plate stack of heat exchanger plates,
- is plate-like and
- is thicker than each of the heat exchanger plates.

Heat exchanger plates usually are comparably thin. Hence, a base body on the one hand can improve mechanical stability of the water oil plate heat exchanger and on the other hand can provide inlets and outlets. In addition, the cooling power of the water oil plate heat exchanger can be adapted to demands by variation of the number of the heat exchanger plates easily. In particular, the heat exchanger plates can have the same height measured in a stacking direction what eases production of the water oil heat exchanger.

Advantageously, the base body can be multipart and can comprise
- a connector body with the heat exchanger water inlet, the heat exchanger water outlet, the heat exchanger oil inlet and heat exchanger the oil outlet and
- a cooling plate, which at least the electronic power switches of the electric power converter are mounted on or in and which closes the heat exchanger water channel.

In this way, the base body provides a plurality of functions. It comprises the connectors for the water oil heat exchanger, improves mechanical stability of the water oil plate heat exchanger and provides heat transfer from the electronic power switches to water of a water flow through the water oil heat exchanger.

In a preferred embodiment of the electric drive unit, the proposed arrangement can be bolted, welded or glued to the housing of the electric drive unit. In this way, said arrangement can be mounted to the housing of the electric drive unit easily.

In a preferred embodiment of the vehicle, the water oil heat exchanger can directly be mounted on or integrated in the housing of the electric drive unit. "Directly mounted" in the above context in particular means "without the use of additional parts, except of optional sealings in-between". In other words, there is body contact between the water oil plate heat exchanger and the housing of the electric drive unit, as the case may be with an optional sealing in-between. In this way, technical complexity of the vehicle can further be reduced.

### BRIEF DESCRIPTION OF DRAWINGS

The invention now is described in more detail hereinafter with reference to particular embodiments, which the invention however is not limited to.
- Fig. 1: shows a schematic view on an arrangement, which comprises a water oil heat exchanger with a base body and which comprises an electric power converter;
- Fig. 2: shows a detailed sectional view of an exemplary arrangement;
- Fig. 3: shows a detailed sectional view of an exemplary arrangement with a water oil plate heat exchanger;
- Fig. 4: shows a detailed sectional view of an exemplary arrangement, which an electric motor is part of;
- Fig. 5: shows a sectional view of a first example of an electric drive unit with an arrangement of the disclosed kind;
- Fig. 6: like Fig. 5, but with a direct connection of the drive unit oil channel and the converter heat exchanger arrangement and
- Fig. 7: shows a schematic view of an electric vehicle.

### DETAILED DESCRIPTION

Generally, same parts or similar parts are denoted with the same/similar names and reference signs hereinafter. The features disclosed in the description apply to parts with the same/similar names respectively reference signs. Indicating the orientation and relative position is related to the associated figure.

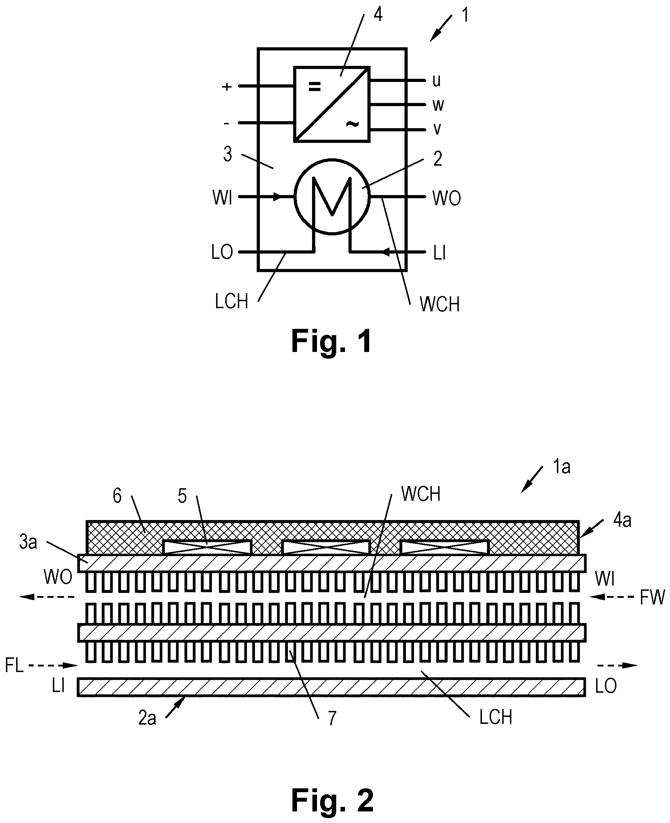

Fig. 1 shows a schematic view on an arrangement 1, which comprises a water oil heat exchanger 2, which has a base body 3 with a heat exchanger water inlet WI, a heat exchanger water outlet WO, a heat exchanger water channel WCH between the heat exchanger water inlet WI and the heat exchanger water outlet WO, a heat exchanger oil inlet LI, a heat exchanger oil outlet LO and a heat exchanger oil channel LCH between the heat exchanger oil inlet LI and the heat exchanger oil outlet LO. Further on, the arrangement 1 comprises an electric power converter 4 with converter inputs +, -, converter outputs u, v, w and a plurality of electronic power switches (not shown in detail in Fig. 1). It should be noted at this point that the proposed solution is not limited to three phases or converter outputs u, v, w but any other number of phases (e.g. six phases) and also systems with parallel paths are possible as well.

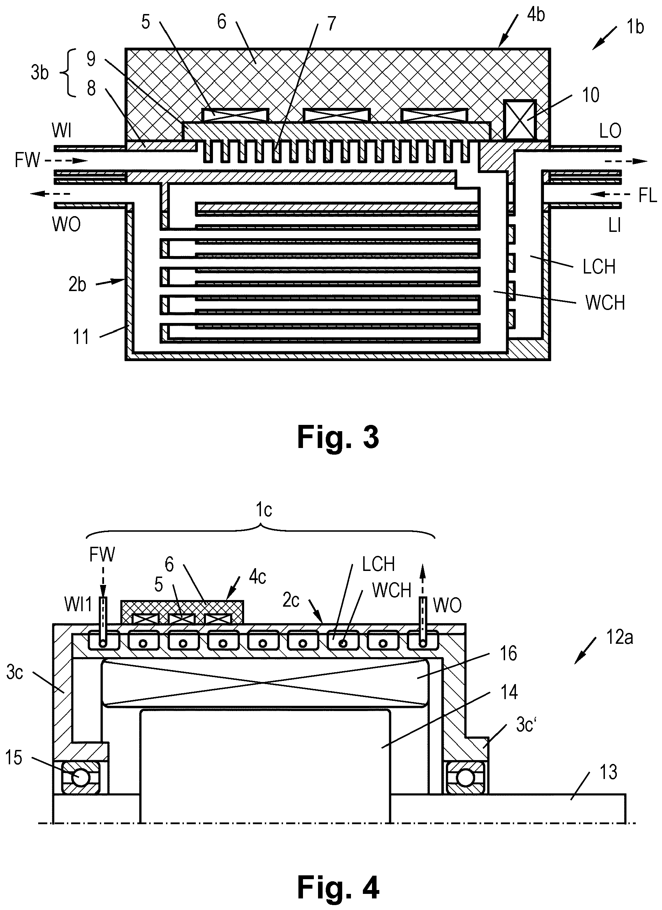

Fig. 2 shows a more detailed sectional view of an arrangement 1a, which comprises a water oil heat exchanger 2a with a base body 3a and an electric power converter 4a. The electronic power switches 5 of the electric power converter 4a are mounted on the base body 3a of the water oil heat exchanger 2a and are enclosed by a converter insulation 6 in this embodiment. The electric power converter 4a may also comprise a control unit for controlling the electronic power switches 5, wherein the control unit can be arranged on the base body 3a as well (not shown in Fig. 2 but see Fig. 3). The base body 3a may comprise cooling pins 7 or cooling fins as depicted in Fig. 2 to improve the heat transfer between a water flow FW through the water channel WCH and an oil flow FL through the oil channel LCH.

The arrangement 1, 1a provides a double function. On the one hand, it enables heat transfer between the water flow FW and the oil flow FL, on the other hand, it enables heat transfer from the electronic power switches 5 to the water of the water flow FW. Fig. 3 shows an arrangement 1b, which is similar to the arrangement 1a of Fig. 2 but where the water oil heat exchanger 2b is embodied as a water oil plate heat exchanger. In detail, the arrangement 1b comprises a connector body 8 and a cooling plate 9, which together form a multipart base body 3b of the water oil heat exchanger 2b. Moreover, the arrangement 1b comprises electronic power switches 5, which for example may be embodied as field effect transistors or insulated-gate bipolar transistors, a converter insulation 6 and a control unit 10. The connector body 8 in this example comprises the heat exchanger water inlet WI, the heat exchanger water outlet WO, the heat exchanger oil inlet LI and the heat exchanger oil outlet LO. The cooling plate 9 closes the heat exchanger water channel WCH and carries the electronic power switches 5 of the electric power converter 4b and in this example additionally the control unit 10 of the electric power converter 4b. Alternatively or in addition, a DC link capacitor of the electric power converter 4b which is electrically connected to the electronic power switches 5 can be mounted on the cooling plate 9 as well.

Fig. 3 moreover shows that sections of the heat exchanger water channel WCH between the heat exchanger water inlet WI and the heat exchanger water outlet WO and sections of the heat exchanger oil channel LCH between the heat exchanger oil inlet LI and the heat exchanger oil outlet LO are alternatingly and pairwise formed by a plurality of heat exchanger plates (not shown in detail in Fig. 3), which together form a plate body or plate stack 11. In particular, the heat exchanger plates may have the same height measured in a stacking direction. The base body 3b is mounted to the plate stack 11, is plate-like and can be thicker than each of the heat exchanger plates like this is the case in Fig. 3.

The water flow FW first passes the cooling pins 7 on the cooling plate 9 and picks up waste heat generated by the electronic power switches 5 and the control unit 10 before it goes into the plate stack 11 where heat transfer from the oil of the oil flow FL to the water of the water flow FW takes place. So, the arrangement 1b again is not only provided for heat exchange between oil and water, but also for cooling the electric power converter 4b. In the embodiment of Fig. 3, the water flow FW first passes the cooling pins 7 and then the plate stack 11. However, the water flow FW may also first pass the plate stack 11 and then the cooling pins 7 in an alternative embodiment. Instead of cooling pins 7 the cooling plate 9 may also comprise cooling fins for cooling the electronic power switches 5 and the control unit 10.

Fig. 4 shows an arrangement 1c, wherein the base body 3c of the water oil heat exchanger 2c is formed by a housing part of a housing of said electric motor 12a. In this example, the housing comprises the base body 3c and an inner housing part 3c'. However, the inner housing part 3c' may also be seen as belonging to the base body 3c. In detail, Fig. 4 shows a sectional view of the electric motor 12a, which comprises a rotor shaft 13, a rotor 14 mounted on the rotor shaft 13, bearings 15, by which the rotor shaft 13 and the rotor 14 are rotatably supported in the housing, and a stator 16 arranged in the housing. The housing or base body 3c comprises an oil channel LCH and water channel WCH, which in this embodiment is formed by a tube running along the oil channel LCH. The oil channel LCH and the water channel WCH in particular may helically run around the stator 16 of the electric motor 12a. On top of the housing or base body 3c, the electric motor 12a comprises electronic power switches 5 of an electric power converter 4c, which are enclosed by a converter insulation 6 and which for example again may be embodied as field effect transistors or insulated-gate bipolar transistors. The electric power converter 4c is used to alternatingly power the windings of the electric motor 12a for generation of a rotating electromagnetic field. In detail, the converter outputs u, v, w can be connected to windings of the electric motor 12a, and the converter inputs +, - can be connected to power source, e.g a battery.

The cooling function of the arrangement 1c is similar to that presented in the examples of Figs. 1 to 3. Again water of the water flow FW pics up heat from oil of the oil flow FL and also from the electronic power switches 5 of an electric power converter 4c. In addition, water of the water flow FW pics up heat from the electric motor 12a, in detail from the rotor 14 and the stator 16. So, the electric motor 12a provides a multiple cooling function besides its provision of mechanical power.

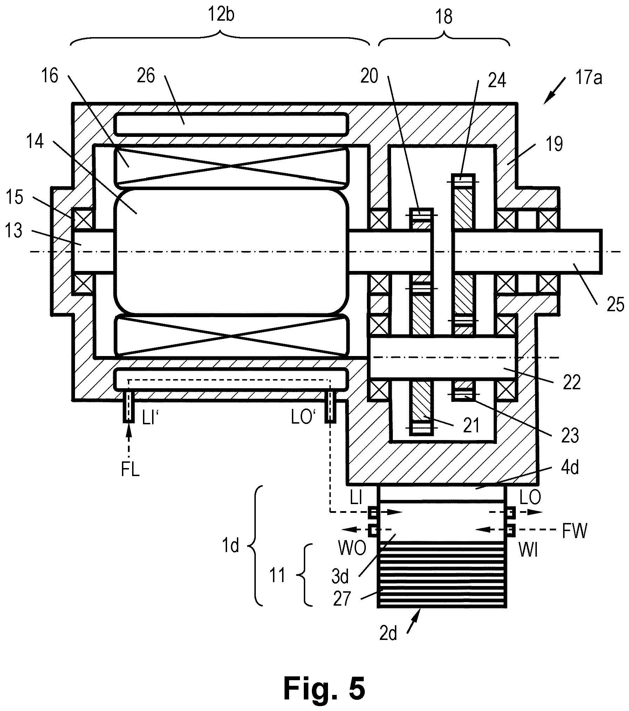

Fig. 5 now shows a sectional view of an example of an electric drive unit ("e-axle") 17a, which comprises an electric motor 12b and a gear unit 18, which is mechanically coupled to the electric motor 12b. Both the electric motor 12b and the gear unit 18 are arranged in a drive unit housing 19.

The electric motor 12b again comprises a rotor shaft 13 with a rotor 14 mounted thereon, bearings 15 and a stator 16. The rotor 14 is supported by means of the bearings 15 and arranged within the stator 16 of the electric motor 12b.

The gear unit 18 comprises a pinion 20 mounted on the rotor shaft 13, a gear wheel 21, an intermediate shaft 22, another pinion 23, another gear wheel 24 and an output shaft 25. The pinion 23 and the gear wheel 21 are mounted to the intermediate shaft 22. The gear wheel 24 finally is mounted to the output shaft 25. The pinion 20 engages with the gear wheel 21, and the pinion 23 engages with the gear wheel 24. Torque and a rotational movement generated by the electric motor 12b is fed into the gear unit 18, which converts said torque and a rotational movement into a higher torque and slower rotational movement at its output shaft 25.

Moreover, the electric drive unit 17a comprises a drive unit oil channel 26 arranged in the drive unit housing 19 at least in the region of the electric motor 12b for cooling the same, and an arrangement 1d with a base body 3d, a plurality of heat exchanger plates 27 forming a plate stack 11 and an electric power converter 4d. The base body 3d and the plate stack 11 together form a water oil heat exchanger 2d.

It should be noted that Fig. 5 just exemplarily shows an electric drive unit 17a and that a drive unit may look differently. For example, an electric drive unit may comprise a planetary gear.

The water oil plate heat exchanger 2d in its base body 3d comprises a heat exchanger water inlet WI, a heat exchanger water outlet WO, a heat exchanger oil inlet LI and a heat exchanger oil outlet LO. The arrangement 1d in detail can look like the arrangement 1b of Fig. 3.

During operation, the electric drive unit 17a generates waste heat, mainly in its electric motor 12b and in its electric power converter 4d. Because natural heat dissipation is not sufficient to keep the electric drive unit 17a cool, heat is drawn away by a water flow FW and an oil flow FL. Usually, the electric motor 12b is oil cooled, the electric power converter 4d is water cooled and the gear unit 18 is passively cooled like this is depicted in Fig. 5.

Concretely, the oil flow FL first passes the drive unit oil channel 26 and then the water oil plate heat exchanger 2d. In detail, it enters the drive unit oil channel 26 through its oil inlet LI' and leaves it through its oil outlet LO'. After leaving the drive unit oil channel 26, it enters the water oil plate heat exchanger 2d through its heat exchanger oil inlet LI and leaves the same through its heat exchanger oil outlet LO. For example, the oil outlet LO' of the drive unit oil channel 26 can be connected to the oil inlet LI of the water oil plate heat exchanger 2d by means of a tube.

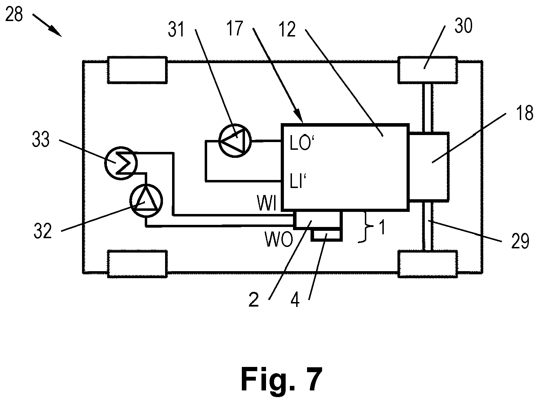

The oil flow FL may be part of an oil based cooling circuit (see Fig. 7 in this context). In Fig. 5 the oil flow FL first passes the drive unit oil channel 26 and then the water oil plate heat exchanger 2d. However, it may also go through the water oil plate heat exchanger 2d first and then pass the drive unit oil channel 26.

The water flow FW enters the water oil plate heat exchanger 2b through its heat exchanger water inlet WI and leaves the same through its heat exchanger water outlet WO. The water flow FL may be part of a water based cooling circuit (see Fig. 7 in this context, too).

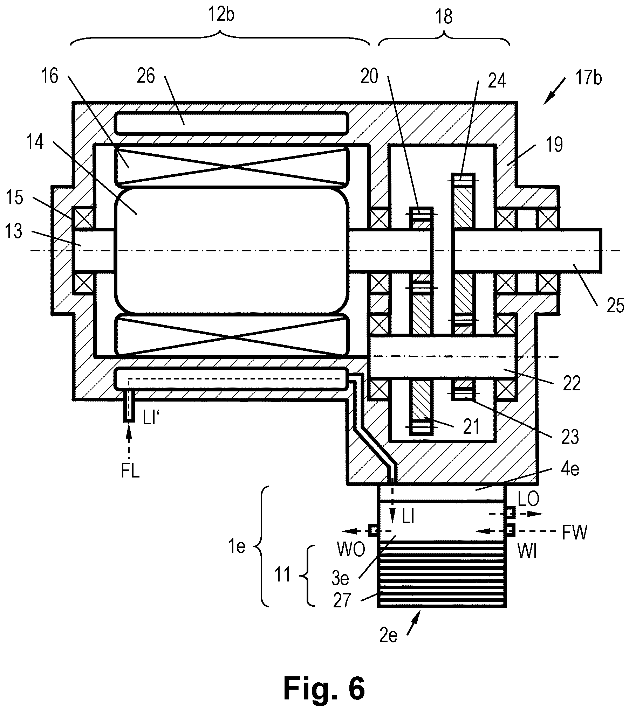

Fig. 6 shows an example of an electric drive unit 17b, which is very similar to the electric drive unit 17a of Fig. 5. In contrast, the drive unit oil channel 26 is directly connected to the water oil plate heat exchanger 2d. For example, the electric power converter 4e may comprise a through hole for connecting the drive unit oil channel 26 to the heat exchanger oil inlet LI. The function of the electric drive unit 17b equals the function of the electric drive unit 17a, however, without the need of a tube between the oil outlet LO' of the drive unit oil channel 26 the oil inlet LI of the water oil plate heat exchanger 2e.

Generally, in all embodiments, the water oil plate heat exchanger 2a..2e can be bolted, welded or glued to the housing 19 of the electric drive unit 17a, 17b or can be bolted, welded or glued to the electric power converter 4a..4e respectively.

Fig. 7 finally shows an electric vehicle 28, which comprises an electric drive unit ("e-axle") 17 with an electric motor 12, a gear unit 18, an electric power converter 4, which is electrically connected to the electric motor 12, and a water oil plate heat exchanger 2 as outlined above. The electric drive unit 17 is mechanically coupled to wheels 30 of the electric vehicle 28 by means of side shafts 29. The electric motor 12 may be provided for powering the electric vehicle 28 permanently in a pure electric car or intermittently, e.g. in combination with a combustion engine in a hybrid car. Moreover, the electric vehicle 28 comprises an oil pump 31, a water pump 32 and a cooler 33. The oil part of the water oil heat exchanger 2 is hydraulically connected to the electric drive unit 17 and in particular can directly be mounted on or integrated in the housing 19 of the electric drive unit 17 (see Figs. 4 to 6). The water pump 32 generates the water flow FW, which transports waste heat from the water oil plate heat exchanger 2 and from the electric power converter 4 to the cooler 33 where it is transferred to the environment. The oil pump 31 generates the oil flow FW, which transports waste heat from the electric motor 12 to the water oil plate heat exchanger 4 where it is transferred to the water flow FW.

It is noted that the invention is not limited to the embodiments disclosed hereinbefore, but combinations of the different variants are possible. In reality, the arrangement 1, 1a..1e, the electric drive unit 17, 17a, 17b and the electric vehicle 28 may have more or less parts than shown in the figures. In Moreover, the description may comprise subject matter of further independent inventions.

It should also be noted that the term "comprising" does not exclude other elements and the use of articles "a" or "an" does not exclude a plurality. Also elements described in association with different embodiments may be combined. It should also be noted that reference signs in the claims should not be construed as limiting the scope of the claims.

### List of Reference Numerals

- 1, 1a..1e: arrangement
- 2, 2a..2e: water oil heat exchanger
- 3, 3a..3e: base body
- 4, 4a..4e: electric power converter
- 5: electronic power switches
- 6: converter insulation
- 7: cooling pin
- 8: connector body
- 9: cooling plate
- 10: control unit
- 11: plate body / plate stack
- 12, 12a, 12b: electric motor
- 13: rotor shaft
- 14: rotor
- 15: bearing
- 16: stator
- 17, 17a, 17b: electric drive unit
- 18: gear unit
- 19: drive unit housing
- 20: pinion
- 21: gear wheel
- 22: intermediate shaft
- 23: pinion
- 24: gear wheel
- 25: output shaft
- 26: drive unit oil channel
- 27: heat exchanger plate
- 28: electric vehicle
- 29: axle
- 30: wheel
- 31: oil pump
- 32: water pump
- 33: cooler
- WI: heat exchanger water inlet
- WO: heat exchanger water outlet
- WCH: heat exchanger water channel
- LI: heat exchanger oil inlet
- LO: heat exchanger oil outlet
- LCH: heat exchanger oil channel
- LI': drive unit oil inlet
- LO': drive unit oil outlet
- +, -: converter input
- u, v, w: converter output
- FL: oil flow
- FW: water flow

## Claims

1. Arrangement (1, 1a..1e), comprising
- a water oil heat exchanger (2, 2a..2e) having a base body (3, 3a..3e) with a heat exchanger water inlet (WI), a heat exchanger water outlet (WO), a heat exchanger water channel (WCH) between the heat exchanger water inlet (WI) and the heat exchanger water outlet (WO), a heat exchanger oil inlet (LI), a heat exchanger oil outlet (LO) and a heat exchanger oil channel (LCH) between the heat exchanger oil inlet (LI) and the heat exchanger oil outlet (LO) and
- an electric power converter (4, 4a..4e) with a plurality of electronic power switches (5),**characterized in that**
- at least the electronic power switches (5) of the electric power converter (4, 4a..4e) are mounted on or in the base body (3, 3a..3e) of the water oil heat exchanger (2, 2a..2e).

2. Arrangement (1, 1a..1e) as claimed in claim 1, **characterized in that** a control unit (10) of the electric power converter (4, 4a..4e) for controlling the electronic power switches (5) and/or a DC link capacitor of the electric power converter (4, 4a..4e) electrically connected to the electronic power switches (5) is/are arranged on or in the base body (3, 3a..3e) of the water oil heat exchanger (2, 2a..2e).

3. Arrangement (1, 1a..1e) as claimed claim 1 or 2, **characterized in** an electric motor (12, 12a, 12b), wherein the base body (3, 3a..3e) of the water oil heat exchanger (2, 2a..2e) forms a housing of said electric motor (12a) or a housing part of a housing of said electric motor (12a).

4. Arrangement (1, 1a..1e) as claimed in any one of claims 1 to 3, **characterized in that** the water oil heat exchanger (2, 2a..2e) is embodied as a water oil plate heat exchanger.

5. Arrangement (1, 1a..1e) as claimed in claim 4, **characterized in that** the water oil plate heat exchanger (2b, 2d) comprises a plate stack (11) of a plurality of heat exchanger plates (27), which alternatingly and pairwise form sections of the heat exchanger water channel (WCH) and sections of the heat exchanger oil channel (LCH) in-between and the base body (3, 3a..3e), which
- is mounted to the plate stack (11) of heat exchanger plates (27),
- is plate-like and
- is thicker than each of the heat exchanger plates (27).

6. Arrangement (1, 1a..1e) unit as claimed in claim 5, **characterized in that** the heat exchanger plates (27) have the same height measured in a stacking direction.

7. Arrangement (1, 1a.. 1e) as claimed in any one of claims 1 to 6, **characterized in that** the base body (3, 3a..3e) is multipart, comprising
- a connector body (8) with the heat exchanger water inlet (WI), the heat exchanger water outlet (WO), the heat exchanger oil inlet (LI) and the heat exchanger oil outlet (LO) and
- a cooling plate (9), which at least the electronic power switches (5) of the electric power converter (4, 4a..4e) are mounted on or in and which closes the heat exchanger water channel (WCH).

8. Electric drive unit (17, 17a, 17b), comprising
- a housing (19),
- an electric motor (12b) arranged in the housing (19),
- a gear unit (18), which is arranged in the housing (19) and which is mechanically coupled to the electric motor (12b),
- a drive unit oil channel (26) arranged in the housing (19) at least in the region of the electric motor (12b) for cooling the same, **characterized in** an arrangement (1, 1a..1e) as claimed in any one of claims 1 to 2 or 4 to 7, which is arranged on or in the housing (19) of the electric motor (12b), wherein
- the electric power converter (4d) of the arrangement (1, 1a..1e) is electrically connected to the electric motor (12b) and wherein
- the heat exchanger oil channel (LCH) of the arrangement (1, 1a..1e) and the drive unit oil channel (26) are interconnected via the heat exchanger oil inlet (LI) or heat exchanger oil outlet (LO).

9. Electric drive unit (17, 17a, 17b) as claimed in claim 8, **characterized in that** the arrangement (1, 1a..1e) is bolted, welded or glued to the housing (19) of the electric drive unit (17, 17a, 17b).

10. Vehicle (28), **characterized in** an electric drive unit (17, 17a, 17b), which is provided to propel the vehicle (28) least partially or intermittently, and an arrangement (1, 1a..1e) as claimed in any one of claims 1 to 7, wherein the power converter (5) is electrically connected to the electric drive unit (17, 17a, 17b) and wherein the water oil heat exchanger (2, 2a..2e) is hydraulically connected to the electric drive unit (17, 17a, 17b).

11. Vehicle (28) as claimed in claim 10, **characterized in that** the water oil heat exchanger (2d) is directly mounted on or integrated in the housing (19) of the electric drive unit (17, 17a, 17b).

12. Vehicle (28), **characterized in** an electric drive unit (17, 17a, 17b) as claimed in claim 8 or 9, which is provided to propel the vehicle (28) least partially or intermittently.
